(19) Europäisches Patentamt
European Patent Office
Office européen des brevets

(11) **EP 1 151 310 B1**

(12) **EUROPÄISCHE PATENTSCHRIFT**

(45) Veröffentlichungstag und Bekanntmachung des Hinweises auf die Patenterteilung:
**02.04.2003  Patentblatt 2003/14**

(51) Int Cl.$^7$: **G01R 27/26**, G01V 3/08, B60R 21/00, G01B 7/287

(21) Anmeldenummer: **00910650.1**

(22) Anmeldetag: **08.02.2000**

(86) Internationale Anmeldenummer:
**PCT/EP00/00984**

(87) Internationale Veröffentlichungsnummer:
**WO 00/048010 (17.08.2000 Gazette 2000/33)**

(54) **MESSVERFAHREN FÜR KAPAZITIVES MESSSYSTEM**

MEASURING METHOD FOR A CAPACITIVE MEASURING SYSTEM

PROCEDE DE MESURE POUR SYSTEME DE MESURE CAPACITIF

(84) Benannte Vertragsstaaten:
**AT BE CH CY DE DK ES FI FR GB GR IE IT LI LU MC NL PT SE**

(30) Priorität: **08.02.1999  LU 90347**

(43) Veröffentlichungstag der Anmeldung:
**07.11.2001  Patentblatt 2001/45**

(73) Patentinhaber: **IEE INTERNATIONAL ELECTRONICS & ENGINEERING S.A.**
**6468 Echternach (LU)**

(72) Erfinder: **WENDT, Christoph**
**D-54292 Trier (DE)**

(74) Vertreter: **Beissel, Jean et al**
**Office Ernest T. Freylinger S.A.**
**234, route d'Arlon**
**B.P. 48**
**8001 Strassen (LU)**

(56) Entgegenhaltungen:
**EP-A- 0 838 697          US-A- 4 339 709**
**US-A- 4 780 662**

## Beschreibung

Die vorliegende Erfindung betrifft ein kapazitives Meßsystem mit mehreren Elektroden, das charakteristische Eigenschaften eines leitenden Körpers wie Form und Ort mittels kapazitiver Kopplung zwischen jeweils zwei dieser Elektroden über den elektrisch leitenden Körper ermittelt. Hierzu werden die einzelnen Elektroden mit einer Wechselspannung beaufschlagt und die jeweils über die Elektroden abfließenden Ströme gemessen. Aus den Werten für die Meßspannungen und die Elektrodenströme können dann die jeweiligen Koppelkapazitäten errechnet werden.

Ein solches Meßsystem ist beispielsweise in der LU-A-88 828 beschrieben. Dieses Meßsystem umfaßt mindestens eine Sendeelektrode und mindestens eine Empfangselektrode, die mit dem leitenden Körper kapazitiv gekoppelt sind. Die Empfangselektroden sind mit einer Auswerteschaltung verbunden, die die kapazitive Kopplung der Sendeantenne mit dem leitenden Körper durch Vergleich des gemessenen Signals mit einem Referenzsignal ermitteln.

Bei der Messung der kapazitiven Kopplung, mit einem geerdeten Meßgerät, stellt die Kapazität des leitenden Körpers gegen Masse eine Fehlerquelle dar. Um diesen Fehler zu beseitigen, wird in der Anmeldung LU 88 828 eine galvanische Trennung des Stromkreises vorgeschlagen. Dabei wird das Signal der Sendeelektrode von der Masse des Systems entkoppelt, um den Einfluß der parasitären Kapazität des zu detektierenden Körpers mit der Masse zu verringern. Eine derartige Entkopplung ist jedoch relativ aufwendig und läßt sich nur schwer in Halbleiter-Technik integrieren.

Aufgabe der vorliegenden Erfindung ist es, ein kapazitives Meßverfahren bzw. ein kapazitives Meßsystem der oben genannten Art vorzuschlagen, das ohne galvanische Trennung der einzelnen Komponenten von der Masse auskommt.

Diese Aufgabe wird gelöst durch ein Verfahren zur Bestimmung der kapazitiven Kopplung von mindestens zwei Elektroden an einen elektrisch leitenden Körper, wobei die einzelnen Elektroden mit einer Wechselspannung beaufschlagt werden und die jeweils über die Elektroden abfließenden Ströme gemessen werden. Erfindungsgemäß werden die über die jeweiligen Elektroden abfließenden Ströme n-mal gemessen werden, $n \geq 2$, wobei die Elektroden bei den einzelnen Messungen mit unterschiedlichen Wechselspannungen beaufschlagt werden, und die Koppelkapazitäten in einer Netzwerkanalyse anhand der jeweiligen Strom- und Spannungswerte der n Messungen berechnet.

Die mehrmalige Messung mit verschiedenen Meßspannungen ermöglicht es anhand der Netzwerkanalyse ein Gleichungssystem aufzustellen, das nach den verschiedenen Kapazitäten (Koppelkapazitäten und parasitäre Kapazitäten) aufgelöst werden kann. Eine Bestimmung der Koppelkapazitäten von zwei Elektroden durch zwei Messungen mit unterschiedlichen Meßspannungen führt über die Kirchhoffschen Gesetze beispielsweise zu einem Gleichungssystem mit 6 Gleichungen, aus denen sowohl die interessierenden Koppelkapazitäten als auch die parasitäre Kapazität und die über diese fließenden parasitären Ströme errechnet werden können. Hierdurch wird eine exakte Berechnung der jeweiligen Koppelkapazitäten ermöglicht.

Im Gegensatz zu dem Stand der Technik ist es folglich bei dem vorliegenden Verfahren nicht notwendig, die parasitäre Kapazität zwischen dem Körper und der Masse technisch bzw. meßtechnisch auszuschalten. Die parasitäre Kapazität kann erhalten bleiben, durch die mehrmalige Messung der Meßgrößen kann sie jedoch bei der Berechnung der interessierenden Koppelkapazitäten richtig berücksichtigt werden und geht somit nicht in die interessierenden Kapazitätswerte ein. Hierdurch wird eine äußerst exakte Bestimmung der interessierenden Werte möglich. Darüber hinaus entfällt bei einer Meßvorrichtung, die nach dem vorliegenden Verfahren arbeitet, der technische Aufwand um die einzelnen Komponenten von der Masse galvanisch zu trennen.

Die Fehleranfälligkeit der berechneten Werte hängt außer von der Genauigkeit der Spannungsquellen und der Strommessung von den Koppelkapazitäten ab, insbesondere dem Verhältnis der Kapazitäten zueinander. Um die Meßgenauigkeit zu optimieren ist es daher vorteilhaft, daß die bei der (i+1)-ten Messung an die einzelnen Elektroden angelegte Wechselspannungen von den Ergebnissen der i-ten Messung abhängig sind, wobei $1 \leq i \leq n-1$. Die Meßspannungen für die zweite Messung der über die Elektroden fließenden Ströme wird gemäß dieser Ausgestaltung vorteilhaft z.B. derart eingestellt, daß die Empfindlichkeit der zweiten Messung im Hinblick auf die bei der ersten Messung ermittelten Kapazitätswerte optimal wird.

Um die Genauigkeit der Bestimmung der Koppelkapazitäten weiter zu erhöhen, werden vorteilhaft mehr als zwei Messungen durchgeführt, d.h. n > 2, und die anhand der Netzwerkanalyse berechneten Koppelkapazitäten zusätzlich mit Hilfe statistischer Methoden ausgewertet.

Im folgenden wird nun eine Ausgestaltung der Erfindung anhand der beiliegenden Figuren beschrieben. Es zeigen:

Fig.1:    das der Messung zugrunde liegende Ersatzschaltbild

Fig.2:    eine schematische Darstellung von zwei aufeinanderfolgenden Messungen.

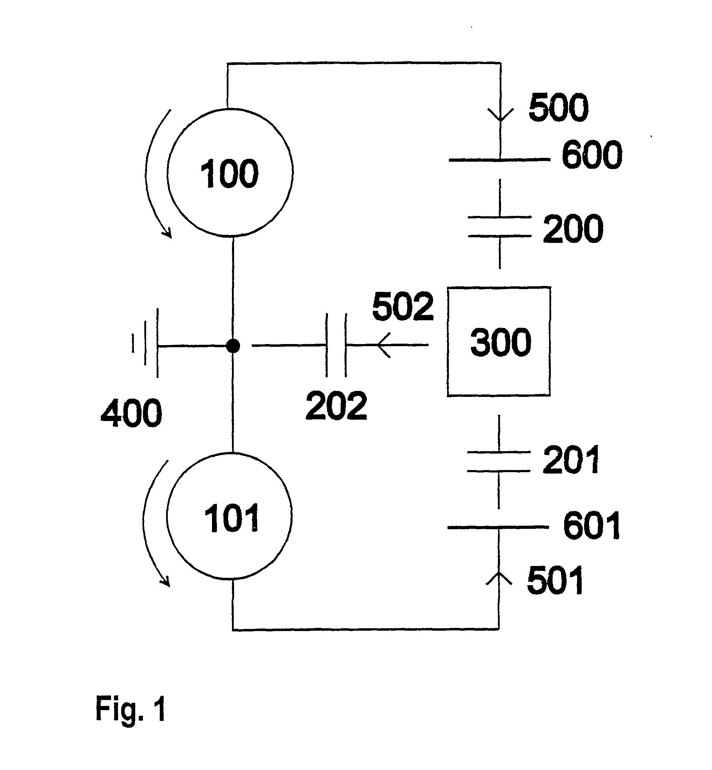

In Fig. 1 ist das der Messung zugrunde liegende Ersatzschaltbild dargestellt. Zu bestimmen sind die Koppelkapazitäten 200, 201 zwischen den Meßelektroden 600, 601 und einem in das elektrische Feld gebrachten Körper 300 sowie die Koppelkapazität 202 zwischen dem Körper 300 und Masse 400. Die an die Meßelektroden 600, 601 angelegten Meßwechselspannungen 100, 101 stimmen in Frequenz und Phase überein und bewirken einen Stromfluß 500, 501 in den Elektroden, welcher von der Meßelektronik bestimmt wird. Ein Teil jedes Elektrodenstromes fließt dabei in die jeweils andere Elektrode, der Rest 502 fließt über die Koppelkapazität 202 nach Masse 400. Werden zwei Messungen mit unterschiedlichen Meßspannungen durchgeführt, lassen sich die Koppelkapazitäten 200, 201, 202 mit Hilfe einer Netzwerkanalyse berechnen. Voraussetzung dafür ist, daß die angelegten Meßspannungen keine Linearkombinationen voneinander sind.

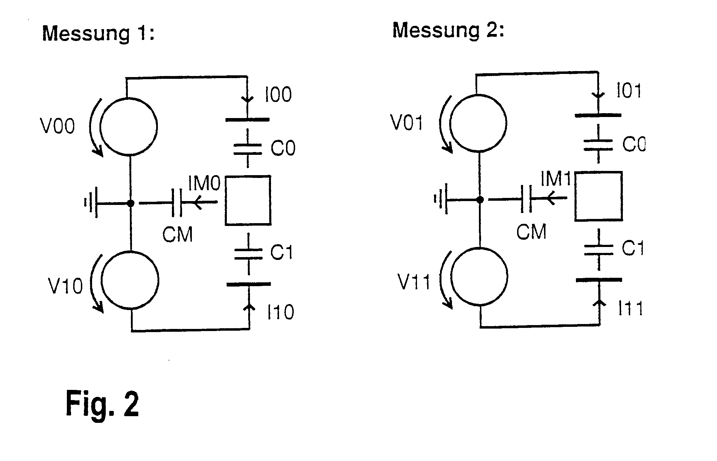

Um die Kapazitäten C0, C1 und CM zu bestimmen, müssen zwei Messungen mit unterschiedlichen Meßspannungen durchgeführt werden (Fig.2). Die erste Messung erfolgt mit den Spannungen V00 und V10. Gemessen werden dabei die Ströme I00 und I10. Bei der zweiten Messung mit den Sensorspannungen V01 und V11 erhält man die Sensorströme I01 und I11.

Zunächst wird mit Hilfe des Kirchhoffschen Maschen- und Knotensatzes ein Gleichungssystem aufgestellt, wobei f die Meßfrequenz ist:

$$0 = -V00 + I00 * \frac{1}{2*\pi*f*C0} + IM0 * \frac{1}{2*\pi*f*CM}$$

$$0 = -V01 + I01 * \frac{1}{2*\pi*f*C0} + IM1 * \frac{1}{2*\pi*f*CM}$$

$$0 = -V10 - IM0 * \frac{1}{2*\pi*f*CM} - I10 * \frac{1}{2*\pi*f*C1}$$

$$0 = -V11 - IM1 * \frac{1}{2*\pi*f*CM} - I11 * \frac{1}{2*\pi*f*C1}$$

$$0 = I00 + I10 - IM0$$

$$0 = I01 + I11 - IM1$$

Das Gleichungssystem wird dann nach C0, C1 und CM aufgelöst, so daß man die Koppelkapazitäten

$$C0 = -\frac{1}{2} \frac{I01*I10 - I00*I11}{\pi f(V00*I11 - V01*I00 + I01*V00 - I10*V01)}$$

$$C1 = \frac{1}{2} \frac{I01*I10 - I00*I11}{\pi f(-V10*I01 + I00*V11 + V11*I10 - I11*V10)}$$

$$CM = \frac{1}{2} \frac{I01*I10 - I00*I11}{\pi f(I01*V00 - V01*I00)}$$

erhält.

Die Fehleranfälligkeit der berechneten Werte hängt außer von der Genauigkeit der Spannungsquellen und der Strommessung von den Koppelkapazitäten ab, insbesondere dem Verhältnis der Kapazitäten zueinander. Um die Meßgenauigkeit zu optimieren ist es daher sinnvoll, die Meßspannungen der 2. Messung vom Ergebnis der 1. Messung abhängig zu machen.

Um die Fehleranfälligkeit der ermittelten Koppelkapazitäten weiter zu verringern, können Messungen mit mehr als zwei Meßspannungskonfigurationen erfolgen und die die berechneten Koppelkapazitätswerte mit Hilfe statistischer Methoden abgesichert werden.

**Patentansprüche**

1. Verfahren zur Bestimmung der kapazitiven Kopplung von mindestens zwei Elektroden (600, 601) an einen elektrisch leitenden Körper (300), wobei die einzelnen Elektroden (600, 601) mit einer Wechselspannung beaufschlagt werden und die jeweils über die Elektroden (600, 601) abfließenden Ströme gemessen werden, **dadurch gekenn-**

**zeichnet, daß** die über die jeweiligen Elektroden (600, 601) abfließenden Ströme n-mal gemessen werden, n ≥ 2, wobei die Elektroden (600, 601) bei den einzelnen Messungen mit unterschiedlichen Wechselspannungen beaufschlagt werden, und daß die Koppelkapazitäten (200, 201, 202) in einer Netzwerkanalyse anhand der jeweiligen Strom- und Spannungswerte der n Messungen ermittelt werden.

2. Verfahren nach Anspruch 1, **dadurch gekennzeichnet, daß** die bei der (i+1)-ten Messung an die einzelnen Elektroden (600, 601) angelegte Wechselspannungen von den Ergebnissen der i-ten Messung abhängig sind, wobei $1 \leq i \leq$ n-1.

3. Verfahren nach einem der Ansprüche 1 oder 2, wobei n > 2 ist, **dadurch gekennzeichnet, daß** die anhand der Netzwerkanalyse berechneten Koppelkapazitäten (200, 201, 202) zusätzlich mit Hilfe statistischer Methoden ausgewertet werden.

4. Verwendung des Verfahrens nach einem der Ansprüche 1 bis 3 zur Bestimmung von Form und/oder Ort eines leitenden Körpers (300).

5. Verwendung des Verfahrens nach einem der Ansprüche 1 bis 3 bei der Positionsbestimmung eines Passagiers in einem Kraftfahrzeug mittels eines kapazitiven Meßsystems.

**Claims**

1. Method for determining the capacitive coupling of at least two electrodes (600, 601) with an electrically conductive body (300), wherein an ac voltage is applied to each of the electrodes (600, 601), and the currents flowing from each of the electrodes (600, 601) are measured, **characterised in that** the currents flowing from each of the electrodes (600, 601) are measured n times, n ≥ 2, wherein different ac voltages are applied to the electrodes (600, 601) for each of the measurements, and that the coupling capacitances (200, 201, 202) are calculated in a network analysis using the respective current and voltage values obtained in the n measurements.

2. Method according to claim 1, **characterised in that** the ac voltages applied to each of the electrodes (600, 601) in the (i+1)-th measurement are dependent on the results of the i-th measurement, wherein $1 \leq i \leq$ n-1.

3. Method according to one of the claims 1 or 2, wherein n > 2, **characterised in that** statistical methods are additionally used to analyse the coupling capacitances (200, 201, 202) calculated from the network analysis.

4. Use of the method according to one of the claims 1 to 3 for determining the shape and/or position of a conductive body (300).

5. Use of the method according to one of the claims 1 to 3 in determining the position of a passenger in a vehicle by means of a capacitive measurement system.

**Revendications**

1. Procédé de détermination du couplage capacitif d'au moins deux électrodes (600, 601) à un corps conduisant l'électricité (300), dans lequel les électrodes individuelles (600, 601) sont excitées par une tension alternative et les courants s'écoulant respectivement par les électrodes (600, 601) sont mesurées, **caractérisé en ce que** les courants s'écoulant respectivement par les électrodes (600, 601) sont mesurés n fois, n ≥ 2, dans lequel les électrodes (600, 601) sont excitées par différentes tensions alternatives, lors des mesures individuelles et que les capacités de couplage (200, 201, 202) sont déterminées à l'aide des valeurs respectives de courant et de tension des n mesures dans une analyse de réseau.

2. Procédé selon la revendication 1, **caractérisé en ce que** les tensions alternatives appliquées aux électrodes individuelles (600, 601) lors de la (i + 1)$^{ième}$ mesure sont dépendantes des résultats de la i$^{ième}$ mesure, où $1 \leq i \leq$ n-1.

3. Procédé selon l'une quelconque des revendications 1 ou 2, dans lequel n > 2, **caractérisé en ce que** les capacités de couplage (200, 201, 202) calculées à l'aide de l'analyse des réseaux, sont évaluées en outre à l'aide de méthodes statistiques.

4. Utilisation du procédé selon l'une quelconque des revendications 1 à 3, pour déterminer la forme et/ou le lieu d'un corps conducteur (300).

5. Utilisation du procédé selon l'une quelconque des revendications 1 à 3, lors de la détermination de la position d'un passager dans une automobile au moyen d'un système de mesure capacitif.

Fig. 1

**Messung 1:**

**Messung 2:**

## Fig. 2